# EUROPEAN PATENT APPLICATION

(11) **EP 2 768 140 A1**
(43) Date of publication of application: **20.08.2014**
(21) Application number: 13275030.8
(22) Date of filing: 13.02.2013
(51) Int. Cl.: H03K 17/10, H03K 17/16

(54) **Method of switching a semiconductor device**

(71) Applicant: Alstom Technology Ltd, 5400 Baden (CH)
(72) Inventor: Crookes, R. William, Stafford ST18 0BW (GB)
(74) Representative: Potter Clarkson LLP

(57) **Abstract**

There is provided a method of switching off a semiconductor device. The semiconductor device includes gate, collector and emitter terminals.

The method comprises the steps of:
(i) applying, upon receipt of a switch-off signal, a voltage to the gate terminal of the semiconductor device at a level which maintains current flowing through the semiconductor device whilst allowing a collector-emitter voltage of the semiconductor device to increase to a predetermined voltage plateau level (81), and maintaining that voltage to the gate terminal of the semiconductor device for a predetermined time period;
(ii) after the predetermined time period, controlling the voltage applied to the gate terminal of the semiconductor device to increase the collector-emitter voltage at a varying ramp rate (82,83,84) until the collector-emitter voltage reaches a predetermined voltage level (85) which exceeds a steady-state value of the collector-emitter voltage of the semiconductor device in its off-state; and
(iii) controlling the voltage applied to the gate terminal of the semiconductor device to maintain the collector-emitter voltage at the predetermined voltage level (85).

## Description

This invention relates to a method of switching off a semiconductor device, a method of switching on a semiconductor device, respective methods of switching off and on a plurality of semiconductor devices in a group of series-connected semiconductor devices, and respective circuits for switching off and on a semiconductor device.

In power transmission networks alternating current (AC) power is typically converted to direct current (DC) power for transmission via overhead lines and/or undersea cables. This conversion removes the need to compensate for the AC capacitive load effects imposed by the transmission line or cable, and thereby reduces the cost per kilometer of the lines and/or cables. Conversion from AC to DC thus becomes cost-effective when power needs to be transmitted over a long distance.

The conversion of AC to DC power is also utilized in power transmission networks where it is necessary to interconnect AC electrical networks operating at different frequencies. In any such power transmission network, converters are required at each interface between AC and DC power to effect the required conversion.

Voltage source converters typically employ switches to carry out rectification and inversion processes necessary to convert AC power to DC power and vice versa. These switches may include semiconductor devices, such as insulated gate bipolar transistors (IGBT), in order to improve the efficiency and switching capabilities of the voltage source converter. However, the low voltage rating of such semiconductor devices relative to the high voltages used in high voltage direct current (HVDC) power transmission necessitates the use of multiple semiconductor devices in series stacks so that the combined voltage rating of the series-connected semiconductor devices is capable of supporting such high voltages.

When switching between on and off states, it is important for the semiconductor devices in each series stack to switch simultaneously so that the voltage applied across a semiconductor device does not exceed its individual voltage rating at any time during operation of the voltage source converter. There is therefore a risk that a semiconductor device that switches too early or too late will be exposed to an applied voltage exceeding its individual voltage rating.

WO 97/43832 discloses a method of controlling the switch-off of an IGBT to provide control over the timing of the switching of individual IGBTs in a series stack. The method comprises the step of applying, upon receipt of a switch-off signal, a voltage to the gate of the IGBT at a level which maintains the current flowing through the IGBT whilst allowing the voltage across the IGBT to increase to a predetermined level and, after a predetermined time period, applying a voltage function to the gate of the IGBT to turn the IGBT off.

WO 2008/032113 relates to a control method and a circuit for MOS-gated power semiconductor switching devices such as IGBTs and MOSFETs. In the control method the voltage change across the semiconductor switching device substantially tracks the voltage change across the diode so as to avoid voltage overshoot.

Each semiconductor device may be protected from damage resulting from over-voltage by connecting a transient voltage suppressor (TVS) between gate and collector terminals of each semiconductor device. When the voltage between the collector and emitter terminals, i.e. the collector-emitter voltage, exceeds the voltage at which the TVS begins to conduct, a current will flow from the collector terminal to the gate terminal and thereby causes the semiconductor device to conduct, thus limiting the extent of the overvoltage.

However, none of the above is concerned with how voltage is shared between the series-connected semiconductor devices, and so individual semiconductor devices may still be exposed to an applied voltage which exceeds its individual rating.

According to a first aspect of the invention, there is provided a method of switching off a semiconductor device, the semiconductor device including gate, collector and emitter terminals, the method comprising the steps of:
(i) applying, upon receipt of a switch-off signal, a voltage to the gate terminal of the semiconductor device at a level which maintains current flowing through the semiconductor device whilst allowing a collector-emitter voltage of the semiconductor device to increase to a predetermined voltage plateau level and maintaining that voltage to the gate terminal of the semiconductor device for a predetermined time period;
(ii) after the predetermined time period, controlling the voltage applied to the gate terminal of the semiconductor device to change the collector-emitter voltage at varying ramp rates until the collector-emitter voltage reaches a predetermined voltage level; and
(iii) controlling the voltage applied to the gate terminal of the semiconductor device to maintain the collector-emitter voltage at the predetermined voltage level.

Prior to the method according to the first aspect of the invention being carried out, the semiconductor device is in an on-state by demanding a negative collector-emitter voltage. The semiconductor device is saturated with charge and therefore does not exit saturation immediately when a voltage is applied to its gate terminal to increase the collector-emitter voltage to the predetermined voltage plateau level following receipt of a switch-off signal. Therefore, the predetermined time period is set to be sufficiently long to ensure that the semiconductor device exits saturation and its collector-emitter voltage reaches the predetermined voltage plateau level before any further changes to the collector-emitter voltage is demanded to complete the switch-off of the semiconductor device. This is because the semiconductor device will respond quickly to any demanded change in collector-emitter voltage after it exits saturation and, since the time to exit saturation can vary for different semiconductor devices in a series stack due to variation in manufacturing tolerances, it is essential to provide sufficient time for each semiconductor device of the series stack to exit saturation so that the semiconductor devices in the series stack can be switched off simultaneously in a reliable fashion.

Simultaneously switching off the semiconductor devices ensures that there will be no destruction of one or more of the semiconductor devices due to a early turn-off resulting in a voltage across a semiconductor device being higher than the voltage rating of the semiconductor device. This assurance allows the use of fewer semiconductor devices in a series stack, thus reducing the cost and improving the reliability of the series stack of semiconductor devices.

After the predetermined time period has elapsed, the collector-emitter voltage of the semiconductor device is further increased at varying ramp rates. Such use of varying ramp rates when, e.g. further increasing the collector-emitter voltage, improves the efficiency and reliability of the switch-off of the semiconductor device maintaining control over the increasing collector-emitter voltage of the semiconductor device, and hence permits control of the sharing of voltage between series-connected such semi-conductor devices, while also permitting optimisation of the ramp rate of the collector-emitter voltage to minimise switching losses and electromagnetic interference.

In contrast, further increasing the collector-emitter voltage at a single constant ramp rate could cause charge in the semiconductor device to reduce to zero and thereby cause an uncontrollable increase in the collector-emitter voltage. An uncontrollable increase in collector-emitter voltage for one or more semiconductor devices in a series stack leads to poor voltage sharing between the series-connected semiconductor devices, which means that any semiconductor device that switches off too early risks being exposed to an applied voltage exceeding its individual voltage rating.

Whilst it is possible to decrease the single constant ramp rate to prevent the charge in the semiconductor device from reducing to zero, doing so would lengthen the switching time and thereby increase the switching losses and electromagnetic interference of the semiconductor device, thus adversely affecting its switching efficiency.

Switching off a semiconductor device in accordance with the method according to the first aspect of the invention therefore enables reliable voltage sharing between a plurality of semiconductor devices in a series stack to facilitate their switch-off in a safe and efficient manner.

Preferably controlling the voltage applied to the gate terminal of the semiconductor device to change the collector-emitter voltage at varying ramp rates includes controlling the voltage applied to the gate terminal of the semiconductor device to increase the collector-emitter voltage at varying ramp rates until the collector-emitter voltage reaches a predetermined voltage level which exceeds a steady-state value of voltage across the semiconductor device in its off-state.

The varying ramp rates are employed until the semiconductor device is switched off, and so the aforementioned control of the collector-emitter voltage and reduction in switching losses and electromagnetic interference is maintained throughout the switch-off procedure.

The step of controlling the voltage applied to the gate terminal of the semiconductor device to increase the collector-emitter voltage at varying ramp rates may involve a first sub-step of varying the ramp rate at a first overall rate.

Such a first overall rate can be chosen to maintain control of the semiconductor device while the capacitance between the gate and collector terminals of the semiconductor device is initially high.

For example, in further embodiments use of the first sub-step includes varying the ramp rate at a first voltage slope and by a second voltage slope, the second voltage slope being steeper than the first voltage slope. For the purposes of this specification, a voltage slope is defined as a constant rate of change of voltage (which can be negative, zero or positive) over a defined period. In this case, the first voltage slope maintains control over the ramp rate at initial high levels of the capacitance between the gate and collector terminals of the semiconductor device, while the second voltage slope reduces switching losses and electromagnetic interference at subsequent lower levels of the capacitance between the gate and collector terminals of the semiconductor device.

Meanwhile the first and second voltage slopes have a combined effect, i.e. an overall effect, of varying the ramp rate at a first overall rate.

Optionally the first sub-step includes a plurality of first and/or second voltage slopes.

Such a combination desirably maintains control of the semiconductor device while helping to further minimise switching losses and electromagnetic interference.

The step of controlling the voltage applied to the gate terminal of the semiconductor device to increase the collector-emitter voltage at varying ramp rates may further involve a second sub-step of varying the ramp rate at a second overall rate which is lower that the first overall rate. Such a lower second overall rate helps to prevent the loss of charge in the semiconductor device and a consequent loss of control as the collector-emitter voltage increases and thereby maintains control over the ramp rate of the collector-emitter voltage..

In contrast, the use of a single constant ramp rate to further increase the collector-emitter voltage would either result in increased switching losses and electromagnetic interference due to inefficient switching or the charge in the semiconductor device will quickly drop to zero and so result in a loss of control of the semiconductor device.

In embodiments employing the use of the first and second sub-steps, the first sub-step may precede the second sub-step, and the second sub-step maintains charge in the semiconductor device prior to the collector-emitter voltage reaching a critical voltage of the semiconductor device and until the collector-emitter voltage reaches the predetermined voltage level. A lower ramp rate, i.e. a second sub-step before the collector-emitter voltage reaches a critical voltage of the semiconductor device helps to avoid the loss of charge and hence loss of control of the semiconductor device.

According to a second aspect of the invention, there is provided a method of switching on a semiconductor device, the semiconductor device including gate, collector and emitter terminals, the method comprising the steps of:
(i) applying, upon receipt of a switch-on signal, a voltage to the gate terminal of the semiconductor device to decrease a collector-emitter voltage of the semiconductor device to a first predetermined voltage plateau level and maintaining that voltage to the gate terminal of the semiconductor device for a predetermined time period;
(ii) after the predetermined time period, controlling the voltage applied to the gate terminal of the semiconductor device to change the collector-emitter voltage at varying ramp rates until the collector-emitter voltage reaches a predetermined voltage level; and
(iii) controlling the voltage applied to the gate terminal of the semiconductor device to maintain the collector-emitter voltage at the predetermined voltage level.

The predetermined time period is set to be sufficiently long to ensure that the semiconductor device exits its off-state (and enters its active state), and its collector-emitter voltage reaches the first predetermined voltage plateau level before any further changes to the collector-emitter voltage is demanded to progress the switch-on of the semiconductor device. This is because the semiconductor device will respond quickly to any demanded change in collector-emitter voltage after it exits its off-state (and enters its active state) and, since the time to exit an off-state (and entry to an active state) can vary for different semiconductor devices in a series stack due to variation in manufacturing tolerances, it is essential to provide sufficient time for each semiconductor device of the series stack to exit its respective off-state so that the semiconductor devices in the series stack can be switched on simultaneously in a reliable fashion.

In the meantime, changing the collector-emitter voltage at varying ramp rates allows the semiconductor device to control aspects of a circuit in which in use it is located, and thereby limit any adverse effects such circuit aspects may have on the semiconductor device.

Preferably controlling the voltage applied to the gate terminal of the semiconductor device to change the collector-emitter voltage at varying ramp-rates until the collector-emitter voltage reaches a predetermined voltage level includes:
(iv) decreasing the collector-emitter voltage to a second predetermined voltage plateau level;
(v) maintaining the collector-emitter voltage at the second predetermined voltage plateau level to regulate the rate of change of current in a circuit in which in use the semiconductor device is located; and
(vi) decreasing the collector-emitter voltage to a voltage level at which the semiconductor device is in its on-state.

In this regard the semiconductor device is considered fully switched on when its collector-emitter voltage is at a minimum.

During the switch-on of the semiconductor device, a residual voltage may be created across a stray inductance of a circuit in which the semiconductor device is located. The residual voltage is the difference between a DC voltage applied across first and second terminals of the circuit and the collector-emitter voltage of the semiconductor device. The residual voltage across the stray inductance of the circuit dictates the rate of change of current in the circuit and, in particular, any anti-parallel protection diode of another limb portion of the circuit. Maintaining the collector-emitter voltage of the semiconductor device at the second predetermined voltage plateau level, i.e. a negative ramp rate followed by a zero ramp rate, regulates the rate of change of current in the circuit and so maintains control over the reverse recovery of any conducting anti-parallel diodes. Such control of the collector-emitter voltage of the semiconductor device enables the conducting diodes to successfully complete reverse recovery and switch to a blocking state.

Otherwise, if the rate of change of current in the circuit is not regulated, the conducting diodes may fail to complete reverse recovery and thereby remain forward biased, and so this would result in an undesirable situation in which the semiconductor device experiences an adverse effect, i.e. it may be exposed to a large voltage during its transition from an off-state to an on-state. This means that, in a series stack of semiconductor devices, any semiconductor device that switches on too late risks being exposed to an applied voltage exceeding its individual voltage rating.

Switching on a semiconductor device in accordance with the method according to the second aspect of the invention therefore enables reliable voltage sharing between a plurality of semiconductor devices in a series stack to facilitate their switch-on in a safe and efficient manner.

In embodiments of each of the first and second aspects of the invention, the method may further include the step of defining the voltage applied to the gate terminal of the semiconductor device using a closed feedback loop which monitors the collector-emitter voltage. This enhances the reliability of the switch-off and switch-on of the semiconductor device.

According to a third aspect of the invention there is provided a method of switching off a plurality of semiconductor devices in a group of series-connected semiconductor devices, each semiconductor device including gate, collector and emitter terminals, the method comprising the steps of:
(i) applying, upon receipt of a switch-off signal, a voltage to the gate terminal of each semiconductor device at a level which maintains current flowing through the semiconductor device whilst allowing a collector-emitter voltage of the semiconductor device to increase to a predetermined voltage plateau level and maintaining that voltage to the gate terminal of the semiconductor device for a predetermined time period;
(ii) after the predetermined time period, controlling the voltage applied to the gate terminal of each semiconductor device to change the collector-emitter voltage at varying ramp rates until the collector-emitter voltage of each semiconductor device reaches a predetermined voltage level; and
(iii) controlling the voltage applied to the gate terminal of each semiconductor device to maintain the collector-emitter voltage of each semiconductor device at the predetermined voltage level.

Conveniently the predetermined period is sufficiently long to allow each of a plurality of semiconductor devices having different saturation exit periods to exit saturation.

According to a fourth aspect of the invention there is provided a method of switching on a plurality of semiconductor devices in a group of series-connected semiconductor devices, each semiconductor device including gate, collector and emitter terminals, the method comprising the steps of:
(i) applying, upon receipt of a switch-on signal, a voltage to the gate terminal of each semiconductor device to decrease a collector-emitter voltage of the semiconductor device to a first predetermined voltage plateau level and maintaining that voltage to the gate terminal of the semiconductor device for a predetermined time period;
(ii) after the predetermined time period, controlling the voltage applied to the gate terminal of each semiconductor device to change the collector-emitter voltage at varying ramp-rates until the collector-emitter voltage of each semiconductor device reaches a predetermined voltage level; and
(iii) controlling the voltage applied to the gate terminal of each semiconductor device to maintain the collector-emitter voltage of each semiconductor device at the predetermined voltage level.

Preferably the predetermined period is sufficiently long to allow each of a plurality of semiconductor devices having different off-state exit periods to exit its off-state.

In a preferred embodiment of the invention the group of series-connected semiconductor devices is electrically connected with at least one anti-parallel diode, and controlling the voltage applied to the gate terminal of each semiconductor device to change the collector-emitter voltage at varying ramp-rates includes maintaining the collector-emitter voltage of each semiconductor device at a second predetermined voltage plateau level until the or each anti-parallel diode completes reverse recovery.

According to a fifth aspect of the invention there is provided a control circuit for switching off a semiconductor device, the semiconductor device including gate, collector and emitter terminals, the control circuit comprising a voltage demand profile generator which, upon receipt of a switch-off signal:
(i) applies a voltage to the gate terminal of the semiconductor device at a level which maintains current flowing through the semiconductor device whilst allowing a collector-emitter voltage of the semiconductor device to increase to a predetermined voltage plateau level and maintains that voltage to the gate terminal of the semiconductor device for a predetermined time period;
(ii) after the predetermined time period, applies a voltage to the gate terminal of the semiconductor device to change the collector-emitter voltage at varying ramp rates until the collector-emitter voltage reaches a predetermined voltage level; and
(iii) applies a voltage to the gate terminal of the semiconductor device to maintain the collector-emitter voltage at the predetermined voltage level.

According to a sixth aspect of the invention there is provided a control circuit for switching on a semiconductor device, the semiconductor device including gate, collector and emitter terminals, the control circuit comprising a voltage demand profile generator which, upon receipt of a switch-on signal:
(i) applies a voltage to the gate terminal of the semiconductor device to decrease a collector-emitter voltage of the semiconductor device to a first predetermined voltage plateau level and maintains that voltage to the gate terminal of the semiconductor device for a predetermined time period;
(ii) after the predetermined time period, applies a voltage to the gate terminal of the semiconductor device to change the collector-emitter voltage at varying ramp-rates until the collector-emitter voltage reaches a predetermined voltage level; and
(iii) applies a voltage to the gate terminal of the semiconductor device to maintain the collector-emitter voltage at the predetermined voltage level.

Preferred embodiments of the invention will now be described, by way of non-limiting examples, with reference to the accompanying drawings in which:
Figure 1 shows, in schematic form, a first circuit including a plurality of semiconductor devices in a group of series-connected semiconductor devices, each of which is switched according to a method of the invention;
Figure 2 shows, in schematic form, a control circuit for controlling the switching of each of the plurality of series-connected semiconductor devices shown in Figure 1;
Figure 3 illustrates, in graph form, a voltage demand profile for switching off each of the plurality of series-connected semiconductor devices shown in Figure 1;
Figure 4 illustrates, in graph form, a change in collector-emitter voltage of one of the plurality of series-connected semiconductor devices shown in Figure 1 when the semiconductor device is controlled in accordance with the voltage demand profile of Figure 3;
Figure 5 illustrates, in graph form, an alternative voltage demand profile for switching off each of the plurality of series-connected semiconductor devices shown in Figure 1;
Figure 6 illustrates, in graph form, a voltage demand profile for switching on each of the plurality of series-connected semiconductor devices shown in Figure 1;
Figure 7 illustrates, in graph form, a change in collector-emitter voltage of one of the plurality of series-connected semiconductor devices shown in Figure 1 when the semiconductor device is controlled in accordance with the voltage demand profile of Figure 5;
Figure 8 shows, in schematic form, a second circuit including a plurality of semiconductor devices in a group of series-connected semiconductor devices, each of which is switched according to a method of the inventions; and
Figure 9 shows, in schematic form, a third circuit including a plurality of semiconductor devices in a group of series-connected semiconductor devices, each of which is switched according to a method of the invention.

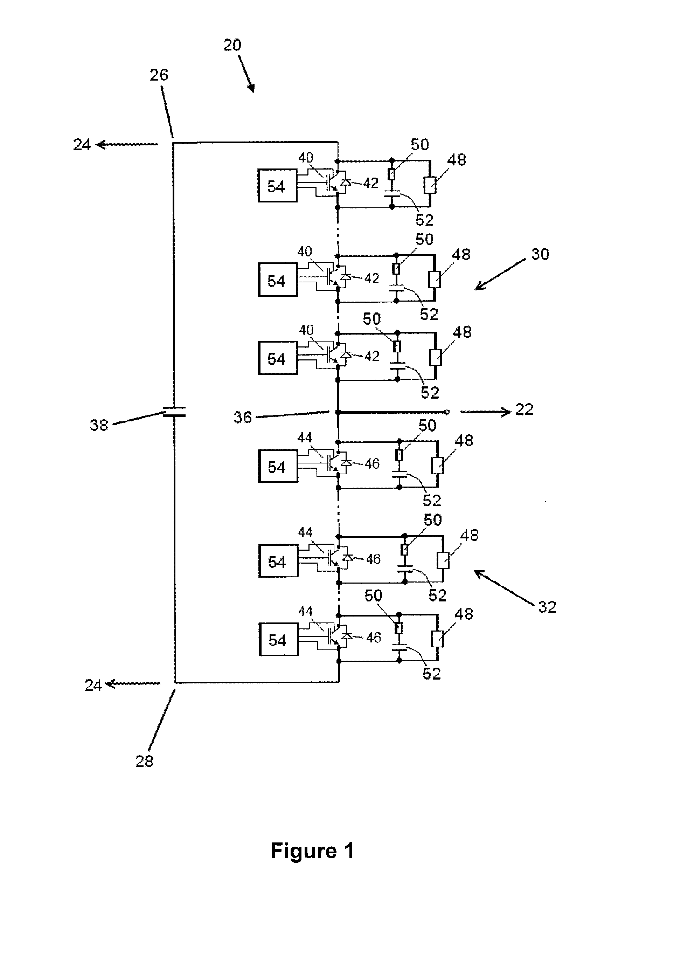

A first voltage source converter 20 for interconnecting AC and DC electrical networks 22,24 is shown in Figure 1.

The first voltage source converter 20 comprises a limb extending between first and second DC terminals 26,28 and having first and second limb portions 30,32 separated by an AC terminal 36.

In use, the first DC terminal 26 is connected to a positive terminal of the DC electrical network 24 which carries a voltage of +V_{DC}/2, the second DC terminal 28 is connected to a negative terminal of the DC electrical network 24 which carries a voltage of -V_{DC}/2 and the AC terminal 36 is connected to the AC electrical network 22.

A DC link capacitor 38 is connected in parallel with the limb between the first and second DC terminals 26,28.

Each limb portion 30,32 of the limb includes a plurality of series-connected switching elements. Each switching element of the first limb portion 30 constitutes a semiconductor switching device in the form of a first IGBT 40 with gate, collector and emitter terminals, and each first IGBT 40 is connected in parallel with a first anti-parallel diode 42. Each switching element of the second limb portion 32 constitutes a semiconductor switching device in the form of a second IGBT 44 with gate, collector and emitter terminals, and each second IGBT 44 is connected in parallel with a second anti-parallel diode 46.

The IGBT 40,44 behaves as a linear device within a narrow range of voltage applied to its gate terminal. Application of a voltage to the gate terminal within the narrow range of voltage will cause a value of collector current to flow at the collector terminal. If the voltage applied to the gate terminal is increased outside the narrow range of voltage, the IGBT 40,44 will be switched 'on', i.e. it will conduct any current in the corresponding limb portion 30,32. If the voltage applied to the gate terminal is reduced outside the narrow range of voltage, the IGBT 40,44 will be switched 'off', i.e. it will block the flow of current in the corresponding limb portion 30,32.

It is envisaged that, in other embodiments of the invention, each IGBT 40,44 may be replaced by a different semiconductor device with gate, emitter and collector terminals, such as an injection enhanced gate transistor (IEGT).

Each switching element further includes a snubber circuit connected in parallel with the corresponding IGBT 40,44. Each snubber circuit includes a resistor 48 connected in parallel with a series connection of another resistor 50 and a capacitor 52. The inclusion of the snubber circuits in the first voltage source converter 20 provides control of voltage sharing between the switching elements of each limb portion 30,32 during steady-state operation of the first voltage source converter 20 by suppressing any rapid rise in voltage across each IGBT 40,44.

In use, the switching elements of the first limb portion 30 are controllable to switch the first limb portion 30 in and out of circuit between the first DC terminal 26 and the AC terminal 36, and the switching elements of the second limb portion 32 are controllable to switch the second limb portion 32 in and out of circuit between the second DC terminal 28 and the AC terminal 36. Such control of the switching elements of the limb portions 30,32 can be used to control the configuration of an AC voltage waveform at the AC terminal 36.

The first voltage source converter 20 further includes a plurality of control circuits 54. Each of the plurality of control circuits 54 is connected with a respective one of the plurality of IGBTs 40,44. The purpose of each control circuit 54 is to control the corresponding IGBT 40,44.

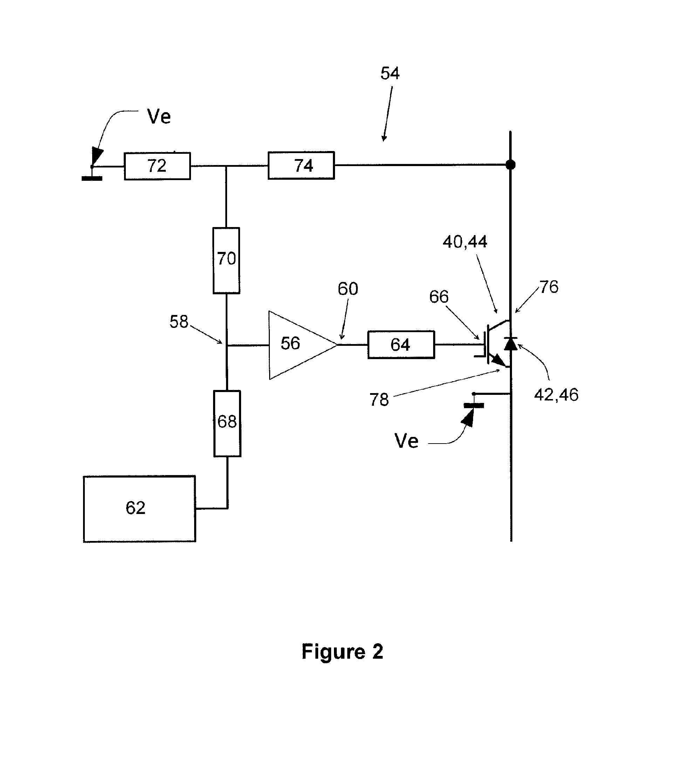

Figure 2 shows, in schematic form, a layout of the connection between a control circuit 54 and an IGBT 40,44. It will be understood that the layout shown in Figure 2 is representative of the connection of each of the plurality of control circuits 54 with a respective one of the plurality of IGBTs 40,44.

Referring to Figure 2, the control circuit 54 includes an amplifier 56 with input and output terminals 58,60 and further includes a signal generator circuit 62.

The output terminal 60 of the amplifier 56 is connected via a resistor 64 to the gate terminal 66 of the IGBT 40,44. In use, the amplifier 56 provides an output voltage for application to the gate terminal 66 to control the IGBT 40,44.

The input terminal 58 of the amplifier 56 is connected via a resistor 68 to the signal generator circuit 62. In use, the signal generator circuit 62 generates a voltage demand profile which is fed in the form of a first voltage signal to the amplifier 56. The voltage demand profile generated by the signal generator circuit 62 is configured to demand a certain collector-emitter voltage between the collector terminal 76 and the emitter terminal 78 of the IGBT 40,44, and so the amplifier 56 is designed so that its output voltage as applied to the gate terminal 66 is controlled accordingly to ensure that the collector-emitter voltage of the IGBT 40,44 adopts the voltage demand profile. In this manner the control circuit 54 controls the collector-emitter voltage of the IGBT 40,44.

The input terminal 58 of the amplifier 56 is further connected via another resistor 70 to a junction formed between a first end of a first compensated attenuator 72 and a first end of a second compensated attenuator 74. A second end of the first compensated attenuator 72 is held at the same voltage Ve as the voltage at the emitter terminal 78 of the IGBT 40,44, while a second end of the second compensated attenuator 74 is connected to the collector terminal 76 of the IGBT 40,44. In this manner the amplifier 56 is able to receive a second voltage signal which corresponds to the actual collector-emitter voltage.

In use, the actual voltage at each of the collector and emitter terminals 76, 78 is attenuated by the compensated attenuators 72,74. The attenuated voltage is fed in the form of the second voltage signal to the amplifier 56, and the second voltage signal is then compared to the first voltage signal. If the actual collector-emitter voltage is lower than what is demanded by the voltage demand profile, the output voltage of the amplifier 56 will reduce. This causes a reduction in the voltage applied to the gate terminal 66, thus causing a reduction in collector current and an increase in collector-emitter voltage. Conversely, if the collector-emitter voltage is higher than what is demanded by the voltage demand profile, the output voltage of the amplifier 56 will increase. This causes an increase in the voltage applied to the gate terminal 66, thus causing an increase in collector current and a reduction in collector-emitter voltage.

The configuration of the control circuit 54 and the IGBT 40,44 as shown in Figure 2 therefore results in a closed feedback loop which is capable of monitoring the actual collector-emitter voltage and making real-time adjustments to define the voltage applied to the gate terminal 66 of the IGBT 40,44 to ensure that the actual collector-emitter voltage of the IGBT 40,44 accurately adopts the voltage demand profile generated by the signal generator circuit 62.

Operation of the first voltage source converter 20 of Figure 1 is described as follows, with reference to Figures 1 to 6.

To interconnect the AC electrical network 22 and the positive terminal of the DC electrical network 24 to allow the transfer of electrical power via the first limb portion 30, each first IGBT 40 is in an on-state to switch the first limb portion 30 into circuit between the first DC terminal 26 and the AC terminal 36, and each second IGBT 44 is in an off-state to switch the second limb portion 32 out of circuit between the second DC terminal 28 and the AC terminal 36. Therefore, current in the first voltage source converter 20 flows in a first direction from the positive terminal of the DC electrical network 24, through the first IGBTs 40 and out of the AC terminal 36 into the AC electrical network 22 or, alternatively, flows in a second direction from the AC terminal 36, through the first anti-parallel diodes 42, out of the first DC terminal 26 and into the DC electrical network 24.

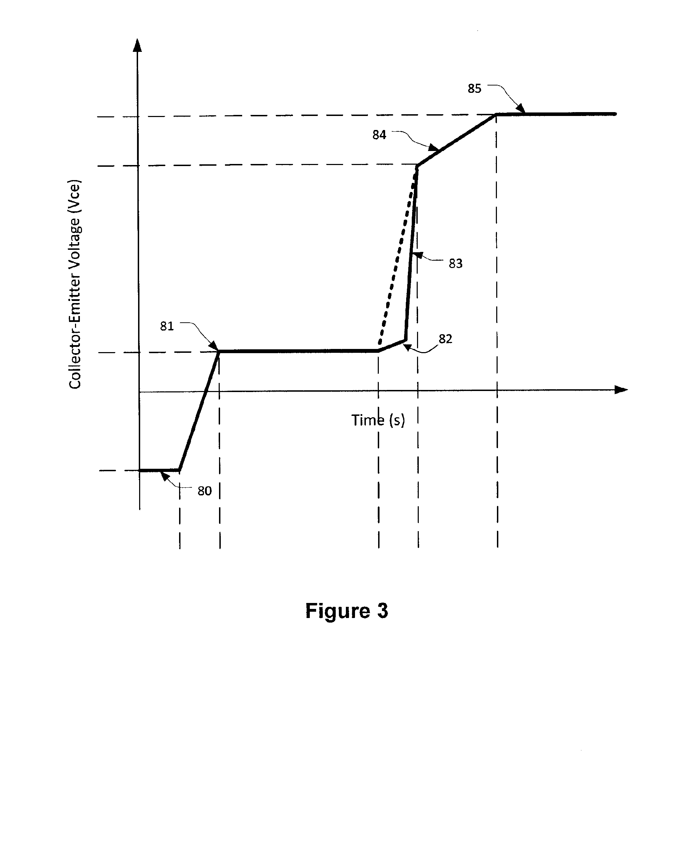

To keep each first IGBT 40 in an on-state, the voltage demand profile generated by each signal generator circuit 62 is configured to demand a negative value 80 of the collector-emitter voltage of the corresponding first IGBT 40 as shown in Figure 3.

When the second limb portion 32 is switched out of circuit between the second DC terminal 28 and the AC terminal 36, a voltage of V_{DC} is present across the switching elements of the second limb portion 32. The second limb portion 32 is rated so that the combined voltage rating of the switching elements of the second limb portion 32 is capable of supporting V_{DC}. The snubber circuits of the second limb portion 32 ensure that the voltage across the second limb portion 32 remains evenly shared between the switching elements of the second limb portion 32 whilst the second limb portion 32 is switched out of circuit between the second DC terminal 28 and the AC terminal 36.

The first IGBTs 40 are then switched off, and so the current in the first voltage source converter 20 is diverted to flow from the first DC terminal 26 to the second DC terminal 28 via the DC link capacitor 38, through the second anti-parallel diodes 46 and out of the AC terminal 36 into the AC electrical network 22. Thereafter, the current commutates out of the positive terminal and the DC link capacitor 38, and so flows from the negative terminal of the DC electrical network 24, through the second anti-parallel diodes 46 and out of the AC terminal 36 into the AC electrical network 22. As such, the second anti-parallel diodes 46 become conducting and forward-biased.

The switch-off of each first IGBT 40 is described as follows, with reference to Figure 3.

Initially each first IGBT 40 is in an on-state.

Upon receipt of a switch-off signal to switch the first IGBT 40 to an off-state, the voltage demand profile, as generated by the signal generator circuit and shown in Figure 3, demands an increase in the collector-emitter voltage of the first IGBT 40 to a relatively low positive voltage plateau level 81. This demand is maintained for a predetermined time period. Initially the first IGBT 40 is saturated with charge and therefore does not exit saturation immediately, but eventually the first IGBT 40 exits saturation and the collector-emitter voltage of the first IGBT 40 rapidly increases to the demanded voltage plateau level 81. Meanwhile current continues to flow through the first IGBT 40.

The predetermined time period is set to be sufficiently long (e.g. a few microseconds) to ensure that the first IGBT 40 exits saturation and its collector-emitter voltage reaches the demanded voltage plateau level 81 before any further change in the collector-emitter voltage of the first IGBT 40 is demanded. This is because the first IGBT 40 will respond quickly to any demanded change in collector-emitter voltage after it exits saturation and, since the time to exit saturation can vary for different first IGBTs 40 due to variation in manufacturing tolerances, it is essential to provide sufficient time for each first IGBT 40 to exit saturation so that the collector-emitter voltages of the plurality of first IGBTs 40 can be controlled to concurrently undergo identical changes.

After the predetermined time period, a first sub-step involves the voltage demand profile demanding a further increase, i.e. a change, in the collector-emitter voltage at a first overall ramp rate which includes a first voltage slope 82 followed by a second voltage slope 83. As mentioned earlier, for the purposes of this specification, a voltage slope is defined as a constant rate of change of voltage (which can be negative, zero or positive) over a defined period.

The capacitance between the gate and collector terminals of the first IGBT 40 is initially high at low values of the collector-emitter voltage. If the ramp rate is too high, it could result in a loss of control over the ramp rate. The capacitance between the gate and collector terminals of the first IGBT 40 however reduces as the collector-emitter voltage increases, and so the ramp rate can be increased at a subsequent higher level of the collector-emitter voltage in order to minimise the switching losses and electromagnetic interference of the IGBT 40,44.

Thus, the ramp rate is configured so that the second voltage slope 83 is steeper than the first voltage slope 82. The first voltage slope 82 maintains control over the ramp rate at initial high levels of the capacitance between the gate and collector terminals of the first IGBT 40, while the second voltage slope 83 reduces switching losses and electromagnetic interference at subsequent lower levels of the capacitance between the gate and collector terminals of the first IGBT 40.

Under some operating conditions the first and second voltage slopes 82,83 may be dispensed with, and instead a single initial slope (as shown in dashed line in Figure 3) included in the voltage demand profile.

In either case, following the first and second voltage slopes 82,83, or following the single initial voltage slope, in a second sub-step the voltage demand profile continues to demand an increase, i.e. a change, in the collector-emitter voltage but at a second overall rate which is lower than the first overall rate. More particularly, a reduced ramp rate 84 is demanded prior to the collector-emitter voltage reaching the critical voltage of the first IGBT 40 in order to maintain charge in the first IGBT 40. The reduced ramp rate 84 is maintained until the collector-emitter voltage reaches a predetermined voltage level 85 which exceeds the steady-state value of the proportion of V_{DC} across each of the first IGBT 40 when in its off-state, i.e. exceeds the DC link voltage of a respective first IGBT 40. The configuration of the ramp rate in this manner prevents the first IGBT 40 reaching its critical voltage as the collector-emitter voltage increases and thereby maintains control over the ramp rate of the collector-emitter voltage.

When the collector-emitter voltage reaches the predetermined voltage level 85, the first IGBT 40 is switched off and the current in the first limb portion 30 decreases to zero. The voltage demand profile then demands that the collector-emitter voltage is maintained at the predetermined voltage level 85 to keep the first IGBT 40 in an off-state.

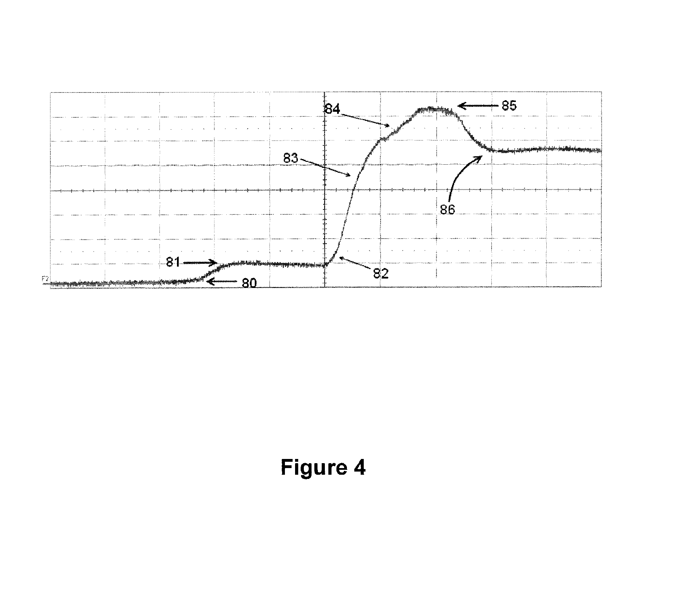

Figure 4 illustrates, in graph form, the change in collector-emitter voltage of the first IGBT 40 during its switch-off, which corresponds to the voltage demand profile shown in Figure 3. It can be seen that the collector-emitter voltage of the first IGBT 40 eventually settles to a steady state value 86 which is dependent on the DC link capacitor voltage and the number of first IGBTs 40 in the first limb portion 30. After the current in the first limb portion 30 reaches zero, the snubber circuit connected in parallel with each first IGBT 40 ensures that the voltage across the first limb portion 30 is evenly shared between the switching elements of the first limb portion 30.

As such the plurality of first IGBTs 40 in the first limb portion 30 can be switched off simultaneously in a reliable fashion. Simultaneously switching off the first IGBTs 40 ensures that there will be no destruction of one or more first IGBTs 40 due to a early turn-off resulting in a voltage across a first IGBT 40 being higher than the voltage rating of the first IGBT 40. This assurance allows the use of fewer IGBTs in a series stack, thus reducing the cost and improving the reliability of the series stack of IGBTs.

Moreover the use of varying ramp rates when further increasing the collector-emitter voltage of each first IGBT 40 during its respective switch-off improves the efficiency and reliability of the switch-off of each first IGBT 40 because it not only maintains control over the increasing collector-emitter voltage, but also permits optimisation of the ramp rate of the collector-emitter voltage to minimise switching losses and electromagnetic interference.

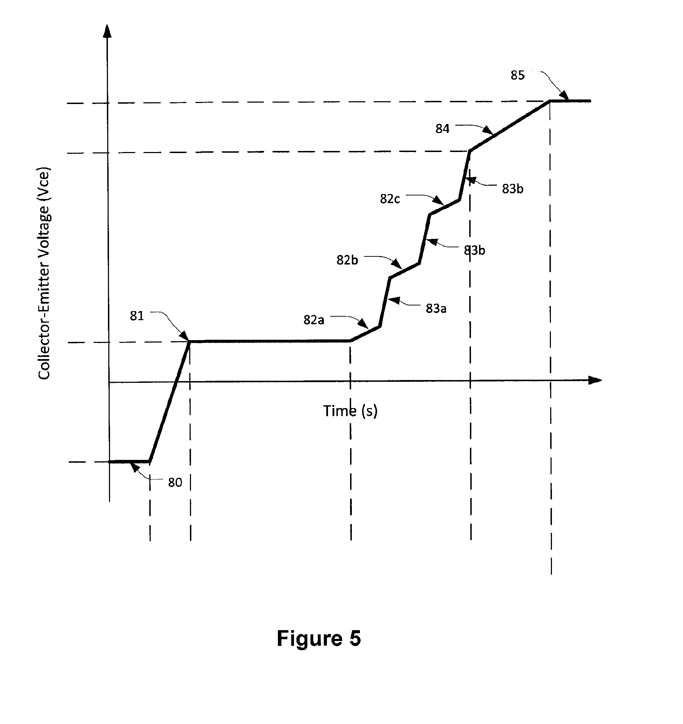

Figure 5 shows a further option for varying the ramp rate within a voltage demand profile to further reduce electromagnetic interference.

Again, on receipt of a switch-off signal the voltage demand profile demands an increase in the collector-emitter voltage of the first IGBT 40 to a relatively low positive voltage plateau level 81.

After a predetermined time period, a first sub-step involves the voltage demand profile demanding a further increase in the collector-emitter voltage at a first ramp rate, i.e. a first voltage slope 82a (which is similar in profile to the first voltage slope 82 mentioned above in connection with Figure 3) and at a second increased ramp rate 83a, which again has a similar profile to the second voltage slope 83 described in connection with Figure 3.

The voltage demand profile includes further first voltage slopes 82b, 82c and further corresponding second voltage slopes 83b, 83c before the collector-emitter voltage reaches the critical voltage of the first IGBT 40. More particularly, a second sub-step involving the reduced ramp rate 84 follows the first sub-step and is maintained until the collector-emitter voltage reaches a predetermined voltage level 85 which exceeds the DC link voltage of the respective first IGBT 40, and so maintains the first IGBT 40 in its off-state.

In still further embodiments of the invention the voltage demand profile may include fewer than or more than the number of first voltage slopes 82a, 82b, 82c and second voltage slopes 83a, 83b, 83c pairs shown in Figure 5, i.e. the method may includes fewer than or more than three first and second voltage slopes. The first and second voltage slopes may also appear in the opposite order within each pair.

In all instances, the inclusion of such pairs in the voltage demand profile provides a desired switching off of the corresponding first IGBT 40 while helping to further reduce electromagnetic interference by reducing the rate of energy change within the said first IGBT 40.

Switching off each first IGBT 40 in the various manners described above therefore enables reliable voltage sharing between the plurality of first IGBTs 40 to facilitate their switch-off in a safe and efficient manner.

To reconnect the AC electrical network 22 and the positive terminal of the DC electrical network 24 to resume the transfer of electrical power via the first limb portion 30, the first IGBTs 40 are switched on to switch the first limb portion 30 back into circuit between the first DC terminal 26 and the AC terminal 36, and so the current in the first voltage source converter 20 is diverted to once again flow from the positive terminal of the DC electrical network 24, through the first IGBTs 40 and out of the AC terminal 36 into the AC electrical network 22.

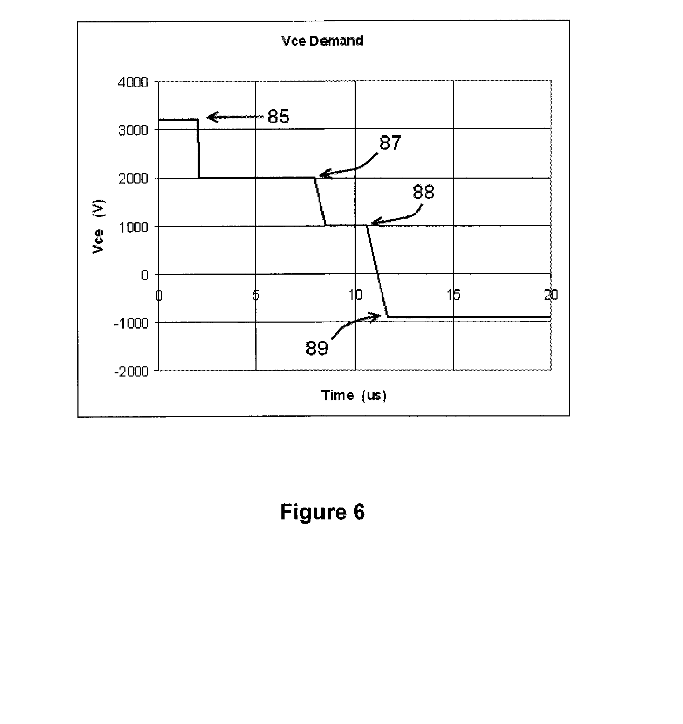

The switch-on of each first IGBT 40 is described as follows, with reference to Figure 6.

Initially each first IGBT 40 is in an off-state and each of the second anti-parallel diodes 46 is conducting and forward biased, as mentioned earlier.

Upon receipt of a switch-on signal to switch the first IGBT 40 to an on-state, the voltage demand profile, as generated by the signal generator circuit and shown in Figure 6, demands a decrease in the collector-emitter voltage of the first IGBT 40 from the earlier-mentioned predetermined voltage level 85 to a first voltage plateau level 87 which is lower than the steady state 'off' voltage 86 shown in Figure 4. This demand is maintained for a predetermined time period. Since the first IGBT 40 is initially in its off-state, the collector-emitter voltage does not adopt the voltage demand profile immediately, but eventually the first IGBT 40 exits its off-state and its collector-emitter voltage rapidly decreases to the demanded first voltage plateau level 87.

The predetermined time period is set to be sufficiently long to ensure that the first IGBT 40 exits its off-state and its collector-emitter voltage reaches the first voltage plateau level 87 before any further change in the collector-emitter voltage of the first IGBT 40 is demanded.

After the predetermined time period, the voltage demand profile demands a change, i.e. a further decrease, in the collector-emitter voltage of the first IGBT 40 to a second voltage plateau level 88. In this manner a decrease to the second voltage plateau level 88 includes a decrease in collector-emitter voltage at a negative ramp rate followed by a different ramp rate, i.e. a zero ramp rate which defines the plateau. The second voltage plateau level 88 is set to define the value of a residual voltage which will be present across a stray inductance of a commutation loop consisting of the first and second limb portions 30,32 and the DC link capacitor 38, the residual voltage being the difference between the steady state voltage 86 and the sum of the collector-emitter voltages of the first IGBTs 40. The residual voltage across the stray inductance of the commutation loop dictates the rate of change of current in the commutation loop and, in particular, the second anti-parallel diodes 46. In this manner the rate of change of current in the commutation loop and in the second anti-parallel diodes 46 can be regulated by setting the second voltage plateau level 88 to a suitable value.

The voltage demand profile then maintains the collector-emitter voltage of the first IGBT 40 at the second voltage plateau level 88 until each of the conducting second anti-parallel diodes 46 completes reverse recovery and switches to a blocking state.

Otherwise, if the rate of change of current in the commutation loop is not regulated, one or more second anti-parallel diodes 46 may fail to complete reverse recovery and thereby be unable to withstand the reverse voltage, and so this would result in an undesirable situation in which the second IGBTs 44 and associated second anti-parallel diodes 46 would have an increased share of the full DC voltage V_{DC}.

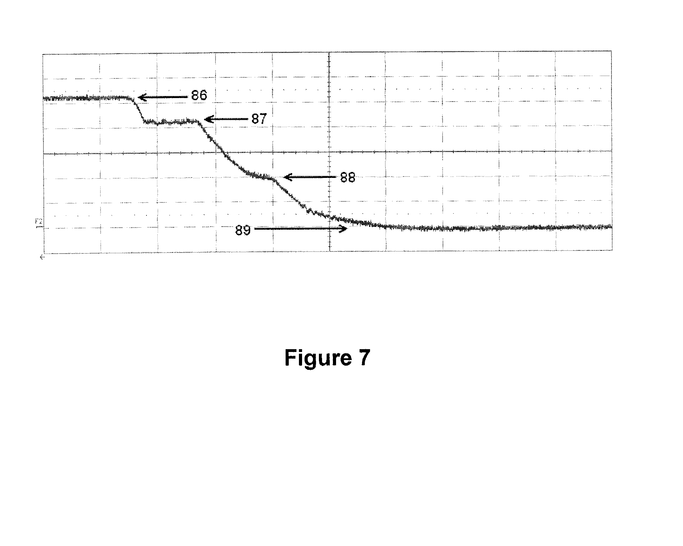

After the reverse recovery of each of the second anti-parallel diodes 46 is complete, the voltage demand profile demands a decrease in the collector-emitter voltage of the first IGBT 40 to a predetermined voltage level, i.e. a negative value 89 to switch on the first IGBT 40. The negative value 89 in Figure 6 is at the same level as the negative value 80 in Figure 3. In each case, as illustrated respectively in Figures 4 and 7, the negative value 80, 89 demanded by the respective voltage demand profiles cannot be achieved by the first IGBT 40 but nevertheless ensures that it is fully on.

Figure 7 illustrates, in graph form, the change in collector-emitter voltage of the first IGBT 40 during its switch-off, which corresponds to the voltage demand profile shown in Figure 6.

Switching on each first IGBT 40 in the manner described above therefore enables reliable voltage sharing between the plurality of first IGBTs 40 to facilitate their switch-on in a safe and efficient manner.

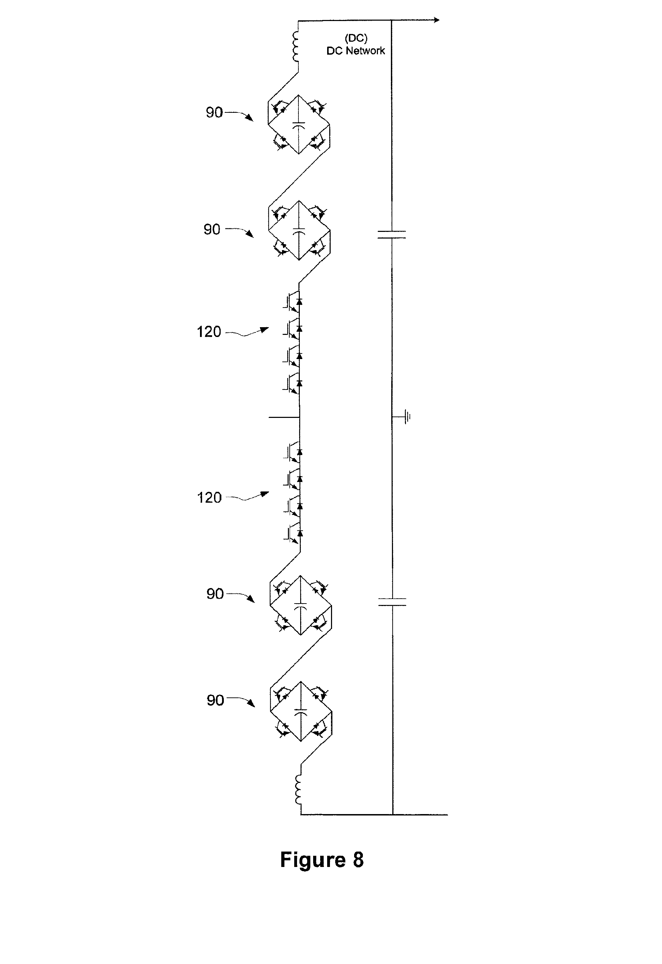

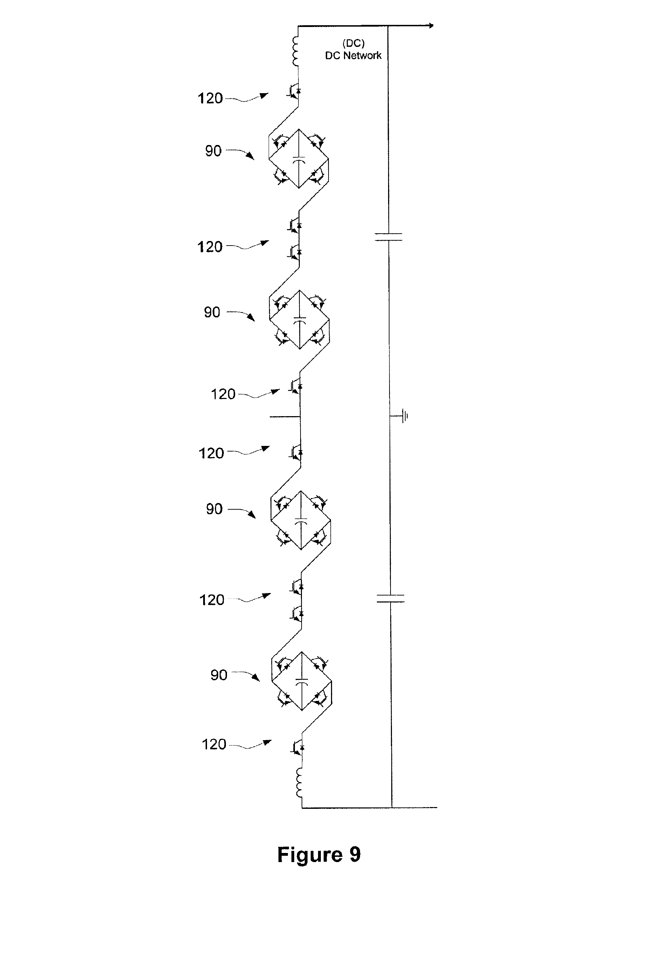

It will be appreciated that the described methods of switching off an IGBT and switching on an IGBT are not limited to voltage source converters and can be used in other types of circuits which employ a plurality of series-connected IGBTs 40,44, even if the IGBTs 40,44 are not all continuously connected in a series string. In other words, as illustrated schematically in Figures 8 and 9, different groups 120 of series-connected IGBTs 40,44 can be shared along a series string which contains other circuit elements such as full bridges 90 and/or half bridges (not shown).

In addition it is envisaged that, in other embodiments of the invention, each control circuit 54 may be replaced by another type of control circuit that consists of alternative arrangements of electronic components which provide the same above-mentioned functions.

## Claims

1. A method of switching off a semiconductor device, the semiconductor device including gate, collector and emitter terminals, the method comprising the steps of:
(i) applying, upon receipt of a switch-off signal, a voltage to the gate terminal of the semiconductor device at a level which maintains current flowing through the semiconductor device whilst allowing a collector-emitter voltage of the semiconductor device to increase to a predetermined voltage plateau level, and maintaining that voltage to the gate terminal of the semiconductor device for a predetermined time period;
(ii) after the predetermined time period, controlling the voltage applied to the gate terminal of the semiconductor device to change the collector-emitter voltage at varying ramp rates until the collector-emitter voltage reaches a predetermined voltage level; and
(iii) controlling the voltage applied to the gate terminal of the semiconductor device to maintain the collector-emitter voltage at the predetermined voltage level.

2. A method according to Claim 1 wherein controlling the voltage applied to the gate terminal of the semiconductor device to change the collector-emitter voltage at varying ramp rates includes controlling the voltage applied to the gate terminal of the semiconductor device to increase the collector-emitter voltage at varying ramp rates until the collector-emitter voltage reaches a predetermined voltage level which exceeds a steady-state value of voltage across the semiconductor device in its off-state.

3. A method according to Claim 2 wherein the step of controlling the voltage applied to the gate terminal of the semiconductor device to increase the collector-emitter voltage at varying ramp rates involves a first sub-step of varying the ramp rate at a first overall rate.

4. A method according to Claim 3 wherein the first sub-step includes varying the ramp rate at a first voltage slope and by a second voltage slope, the second voltage slope being steeper than the first voltage slope.

5. A method according to Claim 4 wherein the first sub-step includes a plurality of first and/or second voltage slopes.

6. A method according to any of Claims 3 to 5 wherein the step of controlling the voltage applied to the gate terminal of the semiconductor device to increase the collector-emitter voltage at varying ramp rates further involves a second sub-step of varying the ramp rate at a second overall rate which is lower than the first overall rate.

7. A method according to Claim 6 wherein the first sub-step precedes the second sub-step, and the second sub-step maintains charge in the semiconductor device prior to the collector-emitter voltage reaching a critical voltage of the semiconductor device and until the collector-emitter voltage reaches the predetermined voltage level.

8. A method of switching on a semiconductor device, the semiconductor device including gate, collector and emitter terminals, the method comprising the steps of:
(i) applying, upon receipt of a switch-on signal, a voltage to the gate terminal of the semiconductor device to decrease a collector-emitter voltage of the semiconductor device to a first predetermined voltage plateau level, and maintaining that voltage to the gate terminal of the semiconductor device for a predetermined time period;
(ii) after the predetermined time period, controlling the voltage applied to the gate terminal of the semiconductor device to change the collector-emitter voltage at varying ramp-rates until the collector-emitter voltage reaches a predetermined voltage level; and
(iii) controlling the voltage applied to the gate terminal of the semiconductor device to maintain the collector-emitter voltage at the predetermined voltage level.

9. A method according to Claim 8 wherein controlling the voltage applied to the gate terminal of the semiconductor device to change the collector-emitter voltage at varying ramp-rates until the collector-emitter voltage reaches a predetermined voltage level includes:
(iv) decreasing the collector-emitter voltage to a second predetermined voltage plateau level;
(v) maintaining the collector-emitter voltage at the second predetermined voltage plateau level to regulate the rate of change of current in a circuit in which in use the semiconductor device is located; and
(vi) decreasing the collector-emitter voltage to a voltage level at which the semiconductor device is in its on-state.

10. A method according to any preceding claim wherein the method further includes the step of defining the voltage applied to the gate terminal of the semiconductor device using a closed feedback loop which monitors the collector-emitter voltage.

11. A method of switching off a plurality of semiconductor devices in a group of series-connected semiconductor devices, each semiconductor device including gate, collector and emitter terminals, the method comprising the steps of:
(i) applying, upon receipt of a switch-off signal, a voltage to the gate terminal of each semiconductor device at a level which maintains current flowing through the semiconductor device whilst allowing a collector-emitter voltage of the semiconductor device to increase to a predetermined voltage plateau level, and maintaining to apply that voltage to the gate terminal of the semiconductor device for a predetermined time period;
(ii) after the predetermined time period, controlling the voltage applied to the gate terminal of each semiconductor device to change the collector-emitter voltage at varying ramp rates until the collector-emitter voltage of each semiconductor device reaches a predetermined voltage level; and
(iii) controlling the voltage applied to the gate terminal of each semiconductor device to maintain the collector-emitter voltage of each semiconductor device at the predetermined voltage level.

12. A method according to Claim 11 wherein the predetermined period is sufficiently long to allow each of a plurality of semiconductor devices having different saturation exit periods to exit saturation.

13. A method of switching on a plurality of semiconductor devices in a group of series-connected semiconductor devices, each semiconductor device including gate, collector and emitter terminals, the method comprising the steps of:
(i) applying, upon receipt of a switch-on signal, a voltage to the gate terminal of each semiconductor device to decrease a collector-emitter voltage of the semiconductor device to a first predetermined voltage plateau level and maintaining that voltage to the gate terminal of the semiconductor device for a predetermined time period;
(ii) after the predetermined time period, controlling the voltage applied to the gate terminal of each semiconductor device to change the collector-emitter voltage at varying ramp-rates until the collector-emitter voltage of each semiconductor device reaches a predetermined voltage level; and
(iii) controlling the voltage applied to the gate terminal of each semiconductor device to maintain the collector-emitter voltage of each semiconductor device at the predetermined voltage level.

14. A method according to Claim 13 wherein the predetermined period is sufficiently long to allow each of a plurality of semiconductor devices having different off-state exit periods to exit its off-state.

15. A method according to Claim 13 or Claim 14 wherein the group of series-connected semiconductor devices is electrically connected with at least one anti-parallel diode, and controlling the voltage applied to the gate terminal of each semiconductor device to change the collector-emitter voltage at varying ramp-rates includes maintaining the collector-emitter voltage of each semiconductor device at a second predetermined voltage plateau level until the or each anti-parallel diode completes reverse recovery.

16. A control circuit for switching off a semiconductor device, the semiconductor device including gate, collector and emitter terminals, the control circuit comprising a voltage demand profile generator which, upon receipt of a switch-off signal:
(i) applies a voltage to the gate terminal of the semiconductor device at a level which maintains current flowing through the semiconductor device whilst allowing a collector-emitter voltage of the semiconductor device to increase to a predetermined voltage plateau level and maintains that voltage to the gate terminal of the semiconductor device for a predetermined time period;
(ii) after the predetermined time period, applies a voltage to the gate terminal of the semiconductor device to change the collector-emitter voltage at varying ramp rates until the collector-emitter voltage reaches a predetermined voltage level; and
(iii) applies a voltage to the gate terminal of the semiconductor device to maintain the collector-emitter voltage at the predetermined voltage level.

17. A control circuit for switching on a semiconductor device, the semiconductor device including gate, collector and emitter terminals, the control circuit comprising a voltage demand profile generator which, upon receipt of a switch-on signal:
(i) applies a voltage to the gate terminal of the semiconductor device to decrease a collector-emitter voltage of the semiconductor device to a first predetermined voltage plateau level and maintains that voltage to the gate terminal of the semiconductor device for a predetermined time period;
(ii) after the predetermined time period, applies a voltage to the gate terminal of the semiconductor device to change the collector-emitter voltage at varying ramp-rates until the collector-emitter voltage reaches a predetermined voltage level; and
(iii) applies a voltage to the gate terminal of the semiconductor device to maintain the collector-emitter voltage at the predetermined voltage level.
